(19) Europäisches Patentamt
European Patent Office
Office européen des brevets

(11) Publication number: **0 425 166 A1**

## (12) EUROPEAN PATENT APPLICATION

(21) Application number: 90311332.2

(22) Date of filing: 16.10.90

(51) Int. Cl.⁵: **H01L 21/321**, H01L 21/306

(30) Priority: 16.10.89 US 421874

(43) Date of publication of application:
02.05.91 Bulletin 91/18

(84) Designated Contracting States:
DE FR GB IT

(71) Applicant: MOTOROLA INC.
1303 East Algonquin Road
Schaumburg Illinois 60196(US)

(72) Inventor: Melaku, Yosias
2608 Ellsworth Street
Berkeley, California 94704(US)
Inventor: Krogh, Ole
110 Point Lobos
San Francisco, California 94121(US)

(74) Representative: Ibbotson, Harold et al
MOTOROLA European Intellectual Property
Operations Jays Close Viables Ind. Estate
Basingstoke Hants RG22 4PD(GB)

(54) Polysilicon etch using bromine.

(57) Bromine ($Br_2$) can be used for etching polysilicon at pressures below 1.33 Pa. The etch is highly selective to oxide and photoresist and more uniform than fluorine/chlorine based chemistries. In accordance with another aspect of the present invention, a small (less than ten percent) amount of oxygen is added to the mixture, further increasing the selectivity to oxide when etching in the presence of oxide.

EP 0 425 166 A1

## POLYSILICON ETCH USING BROMINE

### Background of the Invention

This invention relates to treating semiconductor wafers in a plasma glow discharge and, in particular, to etching polycrystalline silicon ("poly" or "polysilicon") using bromine.

In the prior art, a host of gases have been proposed for etching a variety of materials used in the manufacture of semiconductor wafers, to the point where it is no longer possible to predict with certainty the material being etched, given the gas or gas mixture, and vice-versa. For etching polysilicon, one is told to use $CF_4$, either alone or with $O_2$ or $CCl_4$. In addition, others suggest the use of $C_2F_6$ and $Cl_2$, $CF_3Cl$ or $CF_3Br$, $HCl$, $NF_3$, $CHF_3$, or $BCl_3$.

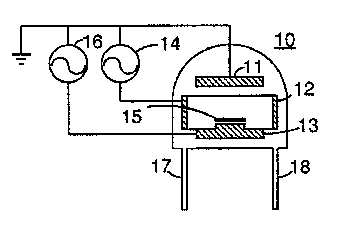

For the particular case of etching polysilicon with bromine ($Br_2$), one has a problem with contradictory teachings in the prior art. For example, U.S. Patent 4,744,861 -Matsunaga et al. - discloses in FIG. 5 thereof that bromine, with or without helium, etches polysilicon at the rate of about 400 nm. per minute. On the other hand, U.S. Patent 4,521,275 - Purdes - discloses that "the chemistry He-$Br_2$ does not etch the silicon at all." It is also disclosed in the '275 patent that "the silicon etch rate is relatively insensitive to the type of silicon involved. As expected, the highest etch rate was seen on the most highly doped polysilicon." The latter quotation refers to chemistries other than pure bromine.

Since the '861 patent discloses no actual data, one might consider the '275 patent more credible. With respect to the present invention, the results obtained are consistent with the data in the '275 patent - up to a point. That point is the subject of the present invention.

In view of the foregoing, it is therefore an object of the present invention to provide an improved process for etching polysilicon with greater uniformity and with greater selectivity to oxide or photoresist.

### Summary of the Invention

The foregoing object has been achieved in the present invention wherein bromine is used for etching polysilicon at pressures below 1.33 Pa. The resulting etch is highly selective to oxide and photoresist and more uniform than fluorine/chlorine based chemistries. The present chemistry is particularly suited to trench etches, as well as etching polysilicon and aluminum. In accordance with another aspect of the present invention, a small (less than ten percent) amount of oxygen is added to the mixture for etching in the presence of oxide. The result is increased selectivity to oxide.

### Brief Description of the Drawings

A more complete understanding of the present invention can be obtained by considering the following detailed description in conjunction with the accompanying drawings, in which:

The FIGURE illustrates a preferred embodiment of apparatus for carrying out the process of the present invention.

### Detailed Description of the Invention

In the FIGURE, plasma reactor 10 comprises an enclosure containing upper electrode 11, side electrode 12 and lower electrode 13. Connected between upper electrode 11 and lower electrode 13 is source 16 of RF power. Upper electrode 11 is preferably grounded. Connected between side electrode 12 and upper electrode 11 is source 14 of RF power. Source 14 preferably produces a relatively high frequency, e.g. 13.56 Mhz. Source 16 preferably produces a relatively low frequency, e.g. 100 khz. The plasma generated between electrodes 11, 12, and 13 etches portions of wafer 15. A bromine etch gas is supplied by way of port 17 and exhausted by way of port 18. Wafer temperature is controlled by controlling the temperature of lower electrode 13, upon which the wafer rests. Lower electrode 13 preferably comprises

EP 0 425 166 A1

suitable heating and cooling means, well known *per se* in the art, for maintaining a wafer temperature of from 0-100°C.

To further illustrate the present invention, the following examples are given. The material being etched is single crystal silicon. Example II is a trench etch, which does not use resist. A resist was not used in example III.

| | I | II | III |
|---|---|---|---|
| wafer diameter | 125 mm. | 200 mm. | 125 nm. |
| wafer temperature | 50-80°C | 50-80°C | 50-80°C |
| LF power | 8-12 watts | 30-90 watts | 8-50 watts |
| HF power | 500 watts | 500 watts | 500 watts |
| gas | $Br_2$ | $Br_2$ | $Br_2 + O_2$ |
| pressure | <1.33 Pa | <1.33 Pa | <1.33 Pa |
| flow | 10-30 SCCM | 10-30 SCCM | 10-30 SCCM |
| etch rate | >120 nm./min. | 300-500 nm./min. | >200 nm./min. |
| uniformity | <±5% | <±5% | <±5% |
| selectivity | | | |
| to oxide | >50:1 | >50:1 | >80:1 |
| to resist | >10:1 | | |

Above 1.33 Pa, the process does not provide commercially useful results. Consistent with the '275 patent, the etch rates for polysilicon would be even higher than those obtained above with single crystal silicon.

There is thus provided by the present invention of an improved method for etching silicon and polysilicon using bromine. Production level etch rates are obtained without loss of uniformity. The handling of bromine, a liquid at room temperature, is not difficult and well know *per se* in the art. Further, one avoids the need to use a fluorocarbon chemistry.

Having thus described the invention, it will be apparent to those of skill in the art that various modifications can be made within the scope of the present invention. For example, the particular powers and frequencies used are not critical but are merely typical of those used presently in the art. Thus, one can easily implement the present invention with existing equipment.

## Claims

1. A process for making a semiconductor device comprising silicon, in which said silicon is etched in the presence of photoresist and/or oxide in a tri-electrode, dual frequency, plasma reactor (10,14,16), characterized in that
the etch gas consists essentially of bromine and said process is carried out at a pressure of less than 1.33 Pa.

2. The process as set forth in claim 1 wherein said etch is carried out at a temperature of from 50-80°C.

3. The process as set forth in claim 1 wherein said silicon is etched in the presence of oxide and said etch gas consists essentially of ten percent or less of oxygen, balance bromine.

4. The process as set forth in claim 1 wherein said silicon comprises polycrystalline silicon.

5. The process as set forth in claim 1 wherein said silicon comprises single crystal silicon.

3

## DOCUMENTS CONSIDERED TO BE RELEVANT

| Category | Citation of document with indication, where appropriate, of relevant passages | Relevant to claim | CLASSIFICATION OF THE APPLICATION (Int. Cl.5) |
|---|---|---|---|
| A | JOURNAL OF VACUUM SCIENCE & TECHNOLOGY B, vol. 6, no. 1, January-February 1988, pages 257-262; A.M. EL-MASRY et al.: "Magnetically enhanced reactive ion etching of silicon in bromine plasmas" * Abstract * | 1-5 | H 01 L 21/321 H 01 L 21/306 |
| A | EP-A-0 203 560 (TEGAL CORP.) * Abstract * | 1-5 | |
| A | EP-A-0 328 350 (FUJITSU) * Abstract * | 2-5 | |
| A | PROCEEDINGS OF THE ELECTROCHEMICAL SOCIETY, vol. 89-9, 1989, pages 486-497; S.V. DAVIES et al.: "Enhancement of selectivity in a polysilicon triode etch process using independent bias voltage control in conjunction with Br2 and Cl2 plasmas" * Whole document * | 1-5 | |

TECHNICAL FIELDS SEARCHED (Int. Cl.5)

H 01 L

The present search report has been drawn up for all claims

| Place of search | Date of completion of search | Examiner |
|---|---|---|
| The Hague | 06 February 91 | GORI P. |